# EUROPÄISCHE PATENTSCHRIFT

(11) **EP 4 086 589 B1**
(45) Veröffentlichungstag und Bekanntmachung des Hinweises auf die Patenterteilung: **27.09.2023**
(21) Anmeldenummer: 22000117.6
(22) Anmeldetag: 02.05.2022
(51) Int. Cl.: G01D 11/24, H03K 17/95

(54) **SENSORGEHÄUSE**
SENSOR CASING
BOÎTIER DE CAPTEUR

(30) Priorität: 04.05.2021 DE 102021002338
(43) Veröffentlichungstag der Anmeldung: 09.11.2022
(73) Patentinhaber: Pepperl+Fuchs SE, 68307 Mannheim (DE)
(72) Erfinder: Drebes, Patrick, 68199 Mannheim (DE)
(74) Vertreter: Koch Müller Patentanwaltsgesellschaft mbH

(56) Entgegenhaltungen:
- EP-A1- 3 961 161
- DE-A1- 2 819 782
- DE-A1- 3 515 033
- DE-A1-102012 108 415

## Beschreibung

Die Erfindung betrifft ein Sensorgehäuse gemäß dem Oberbegriff des Patentanspruchs 1.

Ein gattungsgemäßes Sensorgehäuse mit einem Messkopfteil und einem aus einem Unterteil und einem Oberteil aufgebauten Anschlussteil ist aus der DE 28 19 782 A1 bekannt. In dem Unterteil ist als Klemmenanschlussblock ein Buchsenteil mit Buchsen angeordnet. Dieses Buchsenteil weist auf einer Unterseite Kabeleinführungskanäle auf, über die eine durch die Kabelöffnung geführtes Anschlusskabel mit den Buchsen elektrisch verbunden wird. Das Oberteil weist ein Auswertegeräteteil auf, welches über in die Buchsen eingeführte Stecker mit dem Buchsenteil verbunden wird. Das Messkopfteil wird über Anschlussleitungen mit Kontaktstiften elektrisch verbunden, wodurch ein elektrischer Kontakt mit dem Auswertegeräteteil hergestellt wird.

Eine typische Bauform von Sensoren, wie induktiven oder kapazitativen Näherungssensoren, umfasst ein zweiteiliges Gehäuse. Der Sensor ist in einem Kopfteil angeordnet und in einem Anschlussteil wird eine Kontaktiervorrichtung, z.B. ein Klemmanschlussblock, zum Anschließen eines von außen kommenden Kabels angeordnet. Das Anschlussteil bzw. der von dem Anschlussteil umfasste Raum wird daher häufig auch als Klemmraum bezeichnet.

Der Sensor in dem Kopfteil ist durch elektrische Leitungen mit der Kontaktiervorrichtung verbunden, wofür das Kopfteil und das Anschlussteil entsprechende Durchgangsöffnungen umfassen.

Das Anschlussteil des induktiven Näherungssensors NBB20-U1-UU oder des kapazitiven Sensors CJ15+U1+A2 der Fa. Pepperl + Fuchs GmbH ist beispielsweise zweiteilig aus einem Deckel und einem Unterteil zusammengesetzt, wobei der Deckel mit dem Kopfteil verbunden ist, elektrische Leitungen von einem Sensor in dem Kopfteil in den Deckel geführt werden und in elektrischer Wirkverbindung mit in dem Deckel angeordneten Kontaktstiften stehen. Der Klemmanschlussblock ist in dem Unterteil angeordnet und weist einerseits Buchsen für die Kontaktstifte und andererseits Klemmen für von außen kommende Leitungen auf.

Auch die Standardbauform der Baureihe IQ40 der Fa. SICK AG, z.B. der induktive Näherungssensor IQ40-NPPKKOS weist einen ähnlichen Aufbau auf.

Nachteilig ist, dass durch Kontaktstifte, insbesondere mehrere Kontaktstifte, die Richtung sehr eingeschränkt wird, aus der Deckel und Unterteil zusammen gefügt werden können. Außerdem muss zwischen der Zuverlässigkeit der Kontaktierung und der Leichtgängigkeit der Verbindung von Deckel und Unterteil abgewogen werden.

Je passgenauer und länger die Kontaktstifte sind, umso schwergängiger ist das Trennen oder Verbinden von Deckel und Unterteil.

Aus der DE 35 15 033 A1 ist ein elektronischer Schalter bekannt, welcher aus einem Nachweiskopf mit einem Sensor, einem Kopfgelenk, einem Schalterkasten 7 mit einer Schaltung und einem Aufnahmebehälter besteht, wobei der Nachweiskopf mittels des Kopfgelenkes schwenkbar mit dem Schalterkasten verbunden ist. In dem Schalterkasten ist ein Klemmenanschlussblock angeordnet, so dass beim Einsetzen des Schalterkastens in den Aufnahmebehälter Kontaktstifte in entsprechende Steckerbuchsen eingeführt werden.

Die DE 20 2012 108 415 A1 offenbart eine Schnittstelle zwischen einer Sensoreinheit mit einem Sensor und einem explosionsfesten Gehäuse, wobei der Sensor in einem Rohr angeordnet ist. Ein mit dem Sensor verbundenes Sensorkabel ist mit einer Steckeinheit verbunden, die in einem rohrförmigen Sensorhals angeordnet ist. Die Steckeinheit weist Stiftkontakte auf, die mit dem Sensorkabel verlötet sind. Auf der anderen Seite der Steckeinheit, welche dem explosionsfesten Gehäuse zugewandt ist, befindet sich ein Messverstärker, welcher innerhalb des explosionsfesten Gehäuses angeordnet und auf die Stiftkontakte aufgesetzt ist. Die dem Messverstärker zugewandte Seite der Steckeinheit ist als Stecker ausgebildet, auf welchem ein Buchsenstecker des Messverstärkers aufsitzt, mittels welchem der Messverstärker mechanisch und elektrisch mit der Steckeinheit verbunden ist.

Vor diesem Hintergrund besteht die Aufgabe der Erfindung darin, eine Vorrichtung anzugeben, die den Stand der Technik weiterbildet. Insbesondere soll ein Sensorgehäuse mit einem einfachen, intuitiv zugänglichen und werkzeuglos bedienbaren Mechanismus für die Verbindung zwischen dem Deckel und Unterteil des Anschlussteils bereitgestellt werden.

Die Aufgabe wird durch eine Vorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Sensorgehäuse bereitgestellt, umfassend ein Kopfteil mit einem Sensorraum zur Aufnahme eines Sensors und ein an das Kopfteil angrenzendes Anschlussteil mit einem Klemmraum zur Aufnahme eines Klemmenanschlussblocks.

Das Kopfteil weist in einer an das Anschlussteil angrenzenden Rückwand eine Durchgangsöffnung zur Kabel- und/oder Steckerdurchführung in den Sensorraum auf.

Das Anschlussteil ist mittels eines Verbindungsmittels mit dem Kopfteil verbunden.

Das Anschlussteil weist eine an die Rückwand des Kopfteils angrenzende erste Seitenwand mit einer mit der Durchgangsöffnung des Kopfteils zumindest überlappenden Durchgangsöffnung zur Kabel- und/oder Steckerdurchführung von dem Sensorraum in den Klemmraum auf.

Außerdem weist das Anschlussteil eine zweite Seitenwand mit einer Eingangsöffnung zur Kabel- und/oder Steckerdurchführung in den Klemmraum auf.

In dem Klemmraum ist ein Steckverbindungsteil angeordnet, mit welchem eine elektrische Verbindung zwischen dem in dem Kopfteil angeordneten Sensor und dem Klemmenanschlussblock herstellbar ist.

Das Steckverbindungsteil weist einen aus einem elektrisch isolierenden Material bestehenden Grundkörper, mindestens zwei aus einem elektrisch leitfähigen Material bestehende Kontaktmittel zur elektrischen Kontaktierung des Sensors und mindestens zwei aus einem elektrisch leitfähigen Material bestehende Kontaktflächen zur Verbindung mit dem Klemmenanschlussblock auf.

Die Kontaktmittel sind als Kontaktstifte oder als Kontaktbuchsen einer Steckverbindung zur Herstellung einer elektrischen Wirkverbindung mit einem Steckverbindungsgegenstück des Sensors ausgebildet.

Mindestens zwei Kontaktmittel stehen jeweils mit einer Kontaktfläche in elektrischer Wirkverbindung, wobei die Kontaktflächen auf einer ersten Seitenfläche des Grundkörpers jeweils zueinander beabstandet angeordnet sind und die erste Seitenfläche des Grundkörpers als ebene Fläche ausgebildet ist.

Das Steckverbindungsteil stellt ein elektrisches Verbindungteil mit zwei Schnittstellen dar, um eine elektrische Verbindung zwischen einem in dem Kopfteil angeordneten Sensor und einem in dem Anschlussteil angeordneten Klemmanschlussblock zu gestalten.

Die Kontaktmittel bilden eine Schnittstelle zur elektrischen Kontaktierung des Sensors und die Kontaktflächen eine Schnittstelle zur Verbindung mit einem Klemmanschlussblock.

Es versteht sich, dass der Grundkörper einstückig oder mehrstückig ausgebildet ist und aus einem einzigen oder mehreren unterschiedlichen Materialien, z.B. einem oder mehreren Kunststoffen, besteht. Die Ausbildung der ersten Seitenfläche des Grundkörpers als ebene bzw. plane Fläche ermöglicht eine besonders hohe Freiheit hinsichtlich einer Bewegungsrichtung zum Annähern eines Gegenstücks zum Herstellen eines Kontakts/einer elektrischen Wirkverbindung.

Der Klemmenanschlussblock wird als separates Bauteil in den Klemmraum eingebracht bzw. angeordnet oder der Klemmenanschlussblock wird mit dem Anschlussteil oder einem Teil des Anschlussteils einstückig ausgebildet.

Es versteht sich auch, dass die beiden Schnittstellen an die jeweiligen Anforderungen angepasst sind bzw. angepasst werden können. Insbesondere können die Schnittstellen entsprechend bekannter Normen und/oder Standards ausgebildet sein.

Die Kontaktmittel bilden beispielsweise zusammen mit dem Grundkörper einen standardisierten männlichen oder weiblichen Stecker, z.B. einen weiblichen, vier-poligen M 12 Rundsteckverbinder aus.

Der Sensor kann so auf einfache Weise mittels eines entsprechenden Steckverbindungsgegenstücks, z.B. männlichen Rundsteckverbinders mit dem Steckverbindungsteil verbunden werden, wozu das Steckverbindungsgegenstück durch die Durchgangsöffnungen in dem Kopfteil und dem Anschlussteil in den Klemmraum zumindest hineinragt.

Die zweite Schnittstelle wird durch die auf einer Seitenfläche des Grundkörpers angeordneten Kontaktflächen ausgebildet. Hierdurch wird eine besonders einfache Schnittstelle bereitgestellt, deren Toleranz hinsichtlich Ausrichtung/Positionierung auf einfache Weise durch die Dimensionen und die Anordnung der Kontaktflächen gestaltet werden kann.

Darüber hinaus ermöglichen die Kontaktflächen eine große Freiheit hinsichtlich der Richtung aus der die Gegenkontakte herangeführt werden.

Bei einer zweiteiligen Ausgestaltung des Anschlussteils, bei der ein Kontakt zwischen den Kontaktflächen und einem Klemmanschlussblock erst durch das Zusammenfügen der beiden Teile erreicht wird, wird die Bewegung für das Zusammenfügen durch die Kontaktierung mittels Kontaktflächen nicht weiter eingeschränkt.

Gemäß einer ersten alternativen Ausführungsform bildet ein Teil des Grundkörpers mit den Kontaktmitteln einen weiblichen Stecker oder einen männlichen Stecker.

In einer alternativen Ausführungsform weist der Grundkörper einen die Kontaktmittel umfassenden männlichen Stecker oder einen die Kontaktmittel umfassenden weiblichen Stecker auf.

In einer anderen Ausführungsform weisen die Kontaktflächen jeweils eine Breite von mindestens 1 mm oder mindestens 2 mm auf. Eine Länge der Kontaktflächen ist bevorzugt mindestens 1mm oder mindestens 2 mm oder mindestens 5 mm oder mindestens 1 cm.

Die Größe kann insbesondere an den vorhandenen Platz und die Art und Anordnung von Gegenkontakten angepasst werden. Je größer die Kontaktflächen und die Abstände zwischen den Kontaktflächen gewählt werden, umso mehr Freiheiten ergeben sich hinsichtlich der Positionierung von Gegenkontakten.

In einer weiteren Weiterbildung bildet jeweils ein Kontaktmittel mit einer Kontaktfläche und einem Verbindungsstück ein einstückiges Formteil, z.B. ein Blechformteil, aus. So werden die Kontaktflächen durch Fügen der Kontaktmittel mit dem Grundkörper positioniert und gehalten. Es wird eine besonders einfache Montage des Steckverbindungsteils ermöglicht.

Gemäß einer anderen Weiterbildung weist das Sensorgehäuse eine in dem Klemmraum angeordnete Haltevorrichtung für das Steckverbindungsteil auf.

In einer weiteren Ausführungsform ist das Steckverbindungsteil mit den Kontaktmitteln in Richtung der Durchgangsöffnung zur Kabel- und/oder Steckerdurchführung in den Sensorraum und mit der die Kontaktflächen umfassenden Seitenfläche in Richtung der Eingangsöffnung in dem Klemmraum angeordnet.

Gemäß einer anderen Ausführungsform sind die Kontaktmittel des Steckverbindungsteils konzentrisch zu der Durchgangsöffnung des Kopfteils angeordnet.

In einer weiteren Weiterbildung umfasst das Anschlussteil ein Klemmraumunterteil und einen Klemmraumdeckel, wobei das Klemmraumunterteil und der Klemmraumdeckel in einer Schließrichtung zusammengesetzt sind.

Es versteht sich, dass die Begriffe Klemmraumdeckel und Klemmraumunterteil lediglich zwei aufeinander abgestimmte Teilbereiche des Anschlussteils bezeichnen, ohne eine bestimmte absolute Position oder Ausrichtung festzulegen.

Das Klemmraumunterteil umfasst die zweite Seitenwand mit der Eingangsöffnung.

Der Klemmraumdeckel umfasst die erste Seitenwand mit der Durchgangsöffnung und ist mittels des Verbindungsmittels mit dem Kopfteil verbunden.

Das Steckverbindungsteil ist in dem Klemmraumdeckel angeordnet.

Eine zweiteilige Ausgestaltung des Anschlussteils ist üblich, um einen Zugang zu dem Klemmraum zu ermöglichen und gegebenenfalls die Ausrichtung des Kopfteils relativ zu dem Anschlussteil ändern zu können.

Das Unterteil umfasst typischerweise den Klemmenanschlussblock, an den von außen durch die Eingangsöffnung in den Klemmraum geführte elektrische Leitungen anschließbar sind.

Es versteht sich, dass der Klemmenanschlussblock als separates Bauteil in dem Unterteil angeordnet oder einstückig mit dem Unterteil ausgebildet sein kann.

Durch das Schließen des Anschlussteils, also dem Aufsetzen des Klemmraumdeckels auf das Klemmraumunterteil, stellt das erfindungsgemäße Steckverbindungsteil eine elektrische Wirkverbindung zwischen dem Klemmenanschlussblock und einem elektrischen Anschlussteil des Sensors, z.B. einem Stecker, her.

In einer anderen Weiterbildung entspricht das Sensorgehäuse dem IP 68 Standard oder dem IP 69K Standard.

In einer Weiterbildung wird ein induktiver oder kapazitiver Näherungssensor bereitgestellt, wobei der Näherungssensor ein Sensorgehäuse der vorbeschriebenen Art aufweist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckung ist nicht maßstäblich und weisen, sofern nicht anders angegeben, auch keine ableitbaren geometrischen Relationen zueinander auf. Darin zeigen, die
- Figur 1: einen Querschnitt einer ersten erfindungsgemäßen Ausführungsform eines Sensorgehäuses mit einem Steckverbindungsteil,
- Figur 2: eine perspektivische Ansicht eines Steckverbindungsteils gemäß einer ersten erfindungsgemäßen Ausführungsform,
- Figur 3: eine perspektivische Ansicht eines die Kontaktmittel und Kontaktflächen umfassenden Formteils.

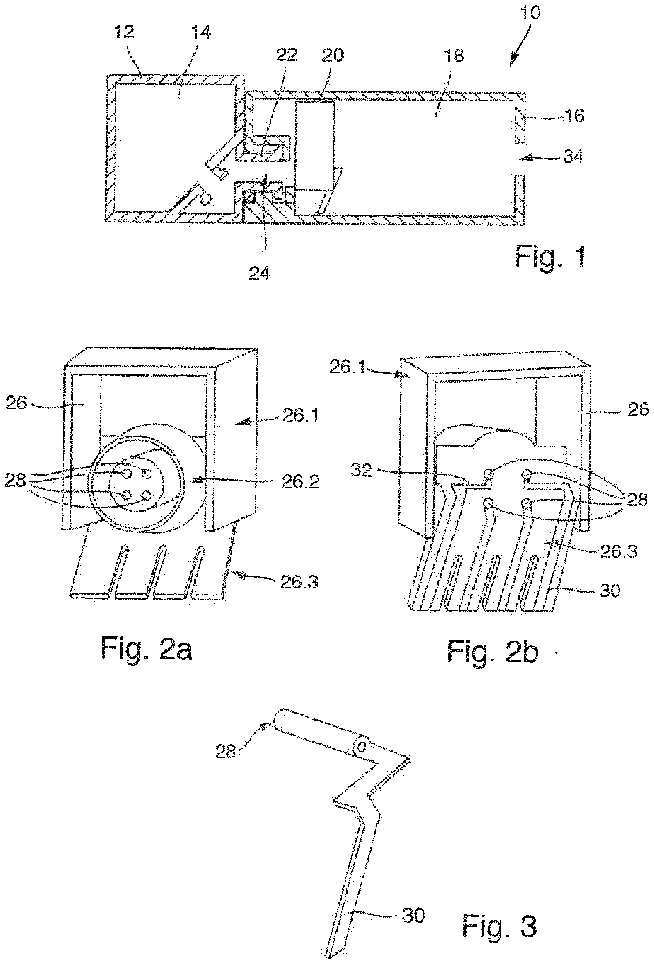

Die Abbildung der Figur 1 zeigt einen Querschnitt eines Sensorgehäuses 10 gemäß einer ersten Ausführungsform, umfassend ein Kopfteil 12 (schraffiert) mit einem Sensorraum 14 zur Aufnahme eines Sensors (nicht dargestellt) und ein Anschlussteil 16 mit einem Klemmraum 18 zur Aufnahme eines Klemmenanschlussblocks (nicht dargestellt). In dem Klemmraum ist ein Steckverbindungsteil 20 angeordnet.

Das Kopfteil 12 ist mittels eines Verbindungsteils 22 mit dem Anschlussteil 16 verbunden, wobei das Verbindungsteil 22 durch eine Durchgangsöffnung in einer ersten Seitenwand des Anschlussteils 16 hineinragt.

Das Verbindungsteil 22 weist eine Durchgangsöffnung 24 zur Kabel- und/oder Steckerdurchführung zwischen dem Sensorraum 14 und dem Klemmraum 18 auf. Außerdem weist das Anschlussteil 16 in einer zweiten Seitenwand eine Eingangsöffnung 34 zur Kabel- und/oder Steckerdurchführung von außen in den Klemmraum 18 auf.

Das Steckverbindungsteil 20 ist vor der Durchgangsöffnung 24 des Verbindungsteils 22 angeordnet.

In der Abbildung der Figur 2 ist eine perspektivische Ansicht des Steckverbindungsteils 20 gemäß einer ersten Ausführungsform aus zwei Blickrichtungen dargestellt.

Das Steckverbindungsteil 20 besteht aus einem Grundkörper 26, vier buchsenförmigen Kontaktmitteln 28 und vier Kontaktflächen 30.

Der Grundkörper weist einen Halterahmen 26.1, einen Steckverbindungsabschnitt 26.2 und eine erste Seitenfläche 26.3 auf. Der Halterahmen 26.1 ist so ausgestaltet, dass er an einer Position vor der Durchgangsöffnung 24 des Verbindungsteils 22 des Kopfteils 12 formschlüssig in den Klemmraum 18 des Anschlussteils 16 positionierbar ist.

In dem Steckverbindungsabschnitt 26.2 sind die Kontaktmittel 28 angeordnet. Die erste Seitenfläche 26.3 ist auf einer von dem Steckverbindungsabschnitt 26.2 abgewandten Seite des Steckverbindungsteils 20 angeordnet und eben ausgebildet.

Die Kontaktmittel 28 durchdringen den Steckverbindungsabschnitt 26.2 und sind an einer Rückseite jeweils mittels eines elektrisch leitfähigen Verbindungstücks 32 mit einer auf der ersten Seitenfläche 26.3 angeordneten Kontaktfläche 30 verbunden.

Die Kontaktmittel 28, die Verbindungsstücke 32 und die Kontaktflächen 30 bilden gemäß einer ersten Ausführungsform zusammen ein einstückiges Formteil aus, wie es in der Abbildung der Figur 3 schematisch dargestellt ist.

## Patentansprüche

1. Sensorgehäuse (10), umfassend ein Kopfteil (12) mit einem Sensorraum (14) zur Aufnahme eines Sensors und ein an das Kopfteil (12) angrenzendes Anschlussteil (16) mit einem Klemmraum (18) zur Aufnahme eines Klemmenanschlussblocks, wobei
- das Kopfteil (12) in einer an das Anschlussteil (16) angrenzenden Rückwand eine Durchgangsöffnung (24) zur Kabel- und/oder Steckerdurchführung in den Sensorraum (14) aufweist,
- das Anschlussteil (16) mittels eines Verbindungsmittels (22) mit dem Kopfteil (12) verbunden ist,
- das Anschlussteil (16) eine an die Rückwand des Kopfteils (12) angrenzende erste Seitenwand mit einer mit der Durchgangsöffnung (24) des Kopfteils (12) zumindest überlappenden Durchgangsöffnung zur Kabel- und/oder Steckerdurchführung von dem Sensorraum (14) in den Klemmraum (18) aufweist und
- das Anschlussteil (16) eine zweite Seitenwand mit einer Eingangsöffnung (34) zur Kabel- und/oder Steckerdurchführung in den Klemmraum (18) aufweist,
**dadurch gekennzeichnet, dass**
- in dem Klemmraum (18) ein Steckverbindungsteil (20) angeordnet ist, mit welchem eine elektrische Verbindung zwischen dem in dem Kopfteil (12) angeordneten Sensor und dem Klemmenanschlussblock herstellbar ist,
- das Steckverbindungsteil (20) einen aus einem elektrisch isolierenden Material bestehenden Grundkörper (26), mindestens zwei aus einem elektrisch leitfähigen Material bestehende Kontaktmittel (28) zur elektrischen Kontaktierung des Sensors und mindestens zwei aus einem elektrisch leitfähigen Material bestehende Kontaktflächen (30) zur Verbindung mit dem Klemmenanschlussblock aufweist,
- die Kontaktmittel (28) als Kontaktstifte oder als Kontaktbuchsen einer Steckverbindung zur Herstellung einer elektrischen Wirkverbindung mit einem Steckverbindungsgegenstück des Sensors ausgebildet sind,
- mindestens zwei Kontaktmittel (28) jeweils mit einer Kontaktfläche (30) in elektrischer Wirkverbindung stehen, und
- die Kontaktflächen (30) auf einer ersten Seitenfläche (26.3) des Grundkörpers (26) jeweils zueinander beabstandet angeordnet sind, wobei die erste Seitenfläche (26.3) des Grundkörpers (26) als ebene Fläche ausgebildet ist.

2. Sensorgehäuse (10) nach Anspruch 1, **dadurch gekennzeichnet, dass** ein Teil des Grundkörpers (26) mit den Kontaktmitteln (28) einen weiblichen Stecker oder einen männlichen Stecker bildet.

3. Sensorgehäuse (10) nach Anspruch 1, **dadurch gekennzeichnet, dass** der Grundkörper (26) einen die Kontaktmittel (28) umfassenden männlichen Stecker oder einen die Kontaktmittel (28) umfassenden weiblichen Stecker aufweist.

4. Sensorgehäuse (10) nach einem der vorangegangenen Ansprüche, **dadurch gekennzeichnet, dass** die Kontaktflächen (30) jeweils eine Breite von mindestens 1 mm oder mindestens 2 mm aufweisen.

5. Sensorgehäuse (10) nach einem der vorangegangenen Ansprüche, **dadurch gekennzeichnet, dass** die Kontaktflächen (30) jeweils eine Länge von mindestens 1mm oder mindestens 2 mm oder mindestens 5 mm oder mindestens 1 cm aufweisen.

6. Sensorgehäuse (10) nach einem der vorangegangenen Ansprüche, **dadurch gekennzeichnet, dass** jeweils eines der Kontaktmittel (28) mit einer der Kontaktflächen (30) und einem Verbindungsstück (32) ein einstückiges Formteil ausbildet.

7. Sensorgehäuse (10) nach einem der vorangegangenen Ansprüche, **dadurch gekennzeichnet, dass** das Sensorgehäuse (10) eine in dem Klemmraum (18) angeordnete Haltevorrichtung für das Steckverbindungsteil (20) aufweist.

8. Sensorgehäuse (10) nach einem der vorangegangenen Ansprüche, **dadurch gekennzeichnet, dass** das Steckverbindungsteil (20) mit den Kontaktmitteln (28) in Richtung der Durchgangsöffnung (24) zur Kabel- und/oder Steckerdurchführung in den Sensorraum (14) und mit der die Kontaktflächen (30) umfassenden ersten Seitenfläche (26.3) in Richtung der Eingangsöffnung (34) in dem Klemmraum (18) angeordnet ist.

9. Sensorgehäuse (10) nach einem der vorangegangenen Ansprüche, **dadurch gekennzeichnet, dass** die Kontaktmittel (28) des Steckverbindungsteils (20) konzentrisch zu der Durchgangsöffnung (24) des Kopfteils (12) angeordnet sind.

10. Sensorgehäuse (10) nach einem der vorangegangenen Ansprüche, **dadurch gekennzeichnet, dass** das Anschlussteil (16) ein Klemmraumunterteil und einen Klemmraumdeckel umfasst, wobei das Klemmraumunterteil und der Klemmraumdeckel in einer Schließrichtung zusammengesetzt sind, das Klemmraumunterteil die zweite Seitenwand mit der Eingangsöffnung (34) umfasst, der Klemmraumdeckel die erste Seitenwand mit der Durchgangsöffnung (24) umfasst und mittels des Verbindungsmittels (22) mit dem Kopfteil (12) verbunden ist und das Steckverbindungsteil (20) in dem Klemmraumdeckel angeordnet ist.

11. Induktiver Näherungssensor oder kapazitiver Näherungssensor, **dadurch gekennzeichnet, dass** der Näherungssensor ein Sensorgehäuse (10) gemäß einem der vorangegangenen Ansprüche aufweist.

## Claims

1. Sensor casing (10) comprising a head part (12) with a sensor chamber (14) for reception of a sensor and a connecting part (16), which adjoins the head part (12), with a terminal chamber (18) for reception of a terminal connecting block, wherein
- the head part (12) has in a rear wall adjoining the connecting part (16) a passage opening (24) for cable and/or plug passage into the sensor chamber (14),
- the connecting part (16) is connected with the head part (12) by way of connecting means (22),
- the connecting part (16) has a first side wall, which adjoins the rear wall of the head part (12), with a passage opening, which at least overlaps the passage opening (24) of the head part (12), for cable and/or plug passage from the sensor chamber (14) into the terminal chamber (18) and
- the connecting part (16) has a second side wall with an entry opening (34) for cable and/or plug passage into the terminal chamber (18),
**characterised in that**
- a plug connecting part (20) by which an electrical connection between the sensor, which is arranged in the head part (12), and the terminal connecting block is producible is arranged in the terminal chamber (18),
- the plug connecting part (20) comprises a base body (26), which consists of an electrically insulating material, at least two contact means (28), which consist of an electrically conductive material, for electrical contact-making with the sensor and at least two contact surfaces (30), which consist of an electrically conductive material, for connection with the terminal connecting block,
- the contact means (28) are constructed as contact pins or as contact sleeves of a plug connection for producing an electrically operative connection with a plug connecting counter-member of the sensor,
- at least two contact means (28) are each in electrically operative connection with a respective contact surface (30) and
- the contact surfaces (30) are arranged at a mutual spacing on a first side surface (26.3) of the base body (26), wherein the first side surface (26.3) of the base body (26) is configured as a planar surface.

2. Sensor housing (10) according to claim 1, **characterised in that** a part of the base body (26) together with the contact means (28) forms a female plug or a male plug.

3. Sensor casing (10) according to claim 1, **characterised in that** the base body (26) comprises a male plug comprising the contact means (28) or a female plug comprising the contact means (28).

4. Sensor casing (10) according to any one of the preceding claims, **characterised in that** the contact surfaces (30) each have a width of at least one 1 millimetre or at least 2 millimetres.

5. Sensor casing (10) according to any one of the preceding claims, **characterised in that** the contact surfaces (30) each have a length of at least 1 millimetre or at least 2 millimetres or at least 5 millimetres or at least 1 centimetre.

6. Sensor casing (10) according to any one of the preceding claims, **characterised in that** each of the contact means (28) forms an integral moulded part with one of the contact surfaces (30) and a connecting member (32).

7. Sensor casing (10) according to any one of the preceding claims, **characterised in that** the sensor casing (10) comprises a holding device, which is arranged in the terminal chamber (18), for the plug connecting part (20).

8. Sensor casing (10) according to any one of the preceding claims, **characterised in that** the plug connecting part (20) is arranged with the contact means (28) in the direction of the passage opening (24) for cable and/or plug passage into the sensor chamber (14) and with the first side surface (26.3), which comprises the contact surfaces (30), in the direction of the entry opening (34) into the terminal chamber (18).

9. Sensor casing (10) according to any one of the preceding claims, **characterised in that** the contact means (28) of the plug connecting part (20) are arranged concentrically with respect to the passage opening (24) of the head part (12).

10. Sensor casing (10) according to any one of the preceding claims, **characterised in that** the connecting part (16) comprises a terminal chamber lower part and a terminal chamber cover, wherein the terminal chamber lower part and the terminal chamber cover are placed together in a closing direction, the terminal chamber lower part comprises the second side wall with the entry opening (34), the terminal chamber cover comprises the first side wall with the passage opening (24) and is connected with the head part (12) by way of the connecting means (22) and the plug connecting part (20) is arranged in the terminal chamber cover.

11. Inductive proximity sensor or capacitive proximity sensor, **characterised in that** the proximity sensor comprises a sensor casing (10) according to any one of the preceding claims.

## Revendications

1. Boîtier de capteur (10) comprenant un élément de tête (12) avec une chambre de capteur (14) destinée à recevoir un capteur et un élément de connexion (16) contigu à l'élément de tête avec un bornier (18) destiné à recevoir un bloc de connecteurs à borne, dans lequel
- l'élément de tête (12) présente dans une paroi arrière contigüe à l'élément de connexion (16) une ouverture de passage (24) pour introduire des câbles et/ou des connecteurs dans la chambre de capteur (14),
- l'élément de connexion (16) est relié à l'élément de tête (12) par le biais d'un moyen de liaison (22),
- l'élément de connexion (16) présente une première paroi latérale contiguë à la paroi arrière de l'élément de tête (12) avec une ouverture de passage se chevauchant au moins avec l'ouverture de passage (24) de l'élément de tête (12) pour faire passer des câbles et/ou des connecteurs de la chambre de capteur (14) au bornier (18) et
- l'élément de connexion (16) présente une deuxième paroi latérale avec une ouverture d'entrée (34) pour introduire des câbles et/ou des connecteurs dans le bornier (18),
**caractérisé en ce que**
- dans le bornier (18) est disposé un élément d'enfichage (20) avec lequel une liaison électrique peut être établie entre le capteur disposé dans l'élément de tête (12) et le bloc de connecteurs à borne,
- cet élément d'enfichage (20) comporte un corps de base (26) constitué d'un matériau électro-isolant, au moins deux moyens de contact (28) constitués d'un matériau électro-conducteur pour établir un contact électrique avec le capteur et au moins deux surfaces de contact (30) constituées d'un matériau électro-conducteur pour établir une liaison avec le bloc de connecteurs à borne,
- les moyens de contact (28) sont configurés comme des fiches de contact ou comme des prises de contact d'un raccord enfichable pour établir une liaison électrique active avec un élément d'enfichage homologue du capteur,
- au moins deux moyens de contact (28) sont chacun en liaison électrique active avec une surface de contact (30) et
- les surfaces de contact (30) sont disposées à l'écart l'une de l'autre sur une première surface latérale (26.3) du corps de base (26), laquelle première surface latérale (26.3) du corps de base (26) est configurée comme une surface plane.

2. Boîtier de capteur (10) selon 1a revendication 1, **caractérisé en ce qu'**une partie du corps de base (26) forme avec les moyens de contact (28) un connecteur femelle ou un connecteur mâle.

3. Boîtier de capteur (10) selon la revendication 1, **caractérisé en ce que** le corps de base (26) comporte un connecteur mâle contenant les moyens de contact (28) ou un connecteur femelle contenant les moyens de contact (28).

4. Boîtier de capteur (10) selon une des revendications précédentes, **caractérisé en ce que** les surfaces de contact (30) présentent chacune une largeur d'au moins 1 mm ou d'au moins 2 mm.

5. Boîtier de capteur (10) selon une des revendications précédentes, **caractérisé en ce que** les surfaces de contact (30) présentent chacune une longueur d'au moins 1 mm ou d'au moins 2 mm ou d'au moins 5 mm ou d'au moins 1 cm.

6. Boîtier de capteur (10) selon une des revendications précédentes, **caractérisé en ce que** chacun des moyens de contact (28) forme avec une des surfaces de contact (30) et une pièce de liaison (32) une pièce moulée monobloc.

7. Boîtier de capteur (10) selon une des revendications précédentes, **caractérisé en ce que** ce boîtier de capteur (10) comporte un dispositif de maintien disposé dans le bornier (18) pour l'élément d'enfichage (20).

8. Boîtier de capteur (10) selon une des revendications précédentes, **caractérisé en ce que** l'élément d'enfichage (20) est disposé avec les moyens de contact (28) en direction de l'ouverture de passage (24) pour introduire des câbles et/ou des connecteurs dans la chambre de capteur (14) et avec la première surface latérale (26.3) contenant les surfaces de contact (30) en direction de l'ouverture d'entrée (34) dans le bornier (18).

9. Boîtier de capteur (10) selon une des revendications précédentes, **caractérisé en ce que** les moyens de contact (28) de l'élément d'enfichage (20) sont disposés de façon concentrique par rapport à l'ouverture de passage (24) de l'élément de tête (12).

10. Boîtier de capteur (10) selon une des revendications précédentes, **caractérisé en ce que** l'élément de connexion (16) contient une partie inférieure de bornier et un couvercle de bornier, dans lequel la patie inférieure de bornier et le couvercle de bornier sont assemblés dans une direction de fermeture, la partie inférieure de bornier contient la deuxième paroi latérale avec l'ouverture d'entrée (34), le couvercle de bornier contient la première paroi latérale avec l'ouverture de passage (24) et est relié à l'élément de tête (12) par le biais du moyen de liaison (22) et l'élément d'enfichage (20) est disposé dans le couvercle de bornier.

11. Capteur de proximité inductif ou capacitif, **caractérisé en ce que** ce capteur de proximité comporte un boîtier de capteur (10) selon une des revendications précédentes.
